# EUROPEAN PATENT SPECIFICATION

(11) **EP 4 545 927 B1**
(45) Date of publication and mention of the grant of the patent: **15.07.2026**
(21) Application number: 24206565.4
(22) Date of filing: 15.10.2024
(51) Int. Cl.: G01L 9/00, G01L 13/02, G01L 19/06

(54) **PRESSURE SENSOR HAVING IMPROVED REJECTION OF UNDESIRED STIMULI**
DRUCKSENSOR MIT VERBESSERTER UNTERDRÜCKUNG VON UNERWÜNSCHTEN EINFLÜSSEN
CAPTEUR DE PRESSION À REJET AMÉLIORÉ DE STIMULI INDÉSIRABLES

(30) Priority: 24.10.2023 IT 202300022215
(43) Date of publication of application: 30.04.2025
(73) Proprietor: STMicroelectronics International N.V., 1228 Plan-les-Ouates, Geneva (CH)
(72) Inventor: DANIELE, Filippo, 20149 Milano (IT); DUQI, Enri, 20126 Milano (IT); BALDO, Lorenzo, 20010 Bareggio (MI) (IT)
(74) Representative: Studio Torta S.p.A.

(56) References cited:
- EP-A1- 3 210 934
- US-A1- 2018 148 323

## Description

### Technical Field

The present invention relates to a pressure sensor, in particular of MEMS ("Micro Electro-Mechanical System") type, having improved rejection of undesired stimuli.

### Background

MEMS pressure sensors are known having a membrane configured to deform as a function of an external pressure to be measured. By detecting the deformation of the membrane, for example through piezoresistors, a measurement of the external pressure may be obtained.

However, as known, MEMS pressure sensors are subject to undesired mechanical stimuli that may cause a spurious, undesired deformation of the membrane. This causes low detection accuracy of MEMS pressure sensors.

Undesired mechanical stimuli may be divided into external stimuli, for example bending of the PCB having the pressure sensor mounted thereon, thermal expansion of the pressure sensor package, humidity, etc.; and internal stimuli, for example thermal expansion of the materials that form the pressure sensor and hysteresis of the residual mechanical stress following temperature variations.

According to one approach, the membrane is formed into a structure suspended with respect to the body of the pressure sensor. This allows the membrane to be decoupled from external mechanical stimuli. However, in this approach, the membrane remains sensitive to internal mechanical stimuli.

According to a different approach, a MEMS pressure sensor comprises a further membrane which is configured not to deform as a function of the external pressure. The further membrane may be used as a reference to cancel the deformation contribution caused by internal mechanical stimuli. However, the fact that the further membrane does not deform as a function of the pressure to be measured causes the pressure sensor to have low sensitivity and high area occupation.

US 2018/148323 A1 and EP 3 210 934 A1 disclose further examples of MEMS pressure sensors. However, the need is felt to enhance the detection performance of said pressure sensors.

The aim of the present invention is to overcome the disadvantages of the prior art.

### Summary

According to the present invention, a pressure sensor is therefore provided, as defined in the attached claims.

### Brief Description of the Drawings

For a better understanding of the present invention, embodiments thereof are now described, purely by way of nonlimiting example, with reference to the attached drawings, wherein:
- Figure 1 shows a top-plan view of a MEMS pressure sensor, according to one embodiment;
- Figure 2 shows a cross-section of the MEMS pressure sensor of Figure 1, along a section line II-II of Figure 1;
- Figure 3 shows a cross-section of a portion of the MEMS pressure sensor of Figure 1, along a section line III-III of Figure 1;
- Figure 4 shows a cross-section of a different portion of the MEMS pressure sensor of Figure 1, along a section line IV-IV of Figure 1;
- Figure 5 shows a circuit diagram of a detection circuit coupeable to the MEMS pressure sensor of Figure 1;
- Figure 6 shows a simplified view of a portion of the MEMS pressure sensor of Figure 1, in use;
- Figure 7 shows a cross-section of a MEMS pressure sensor, according to a different embodiment; and
- Figure 8 shows a circuit diagram of a detection circuit coupeable to a MEMS pressure sensor, according to one embodiment.

### Description of Embodiments

The following description refers to the arrangement shown in the attached Figures; consequently, expressions such as "above", "below", "lower", "upper", "right", "left", "top", "bottom", and the like, relate to the attached Figures and should not be interpreted in a limiting manner.

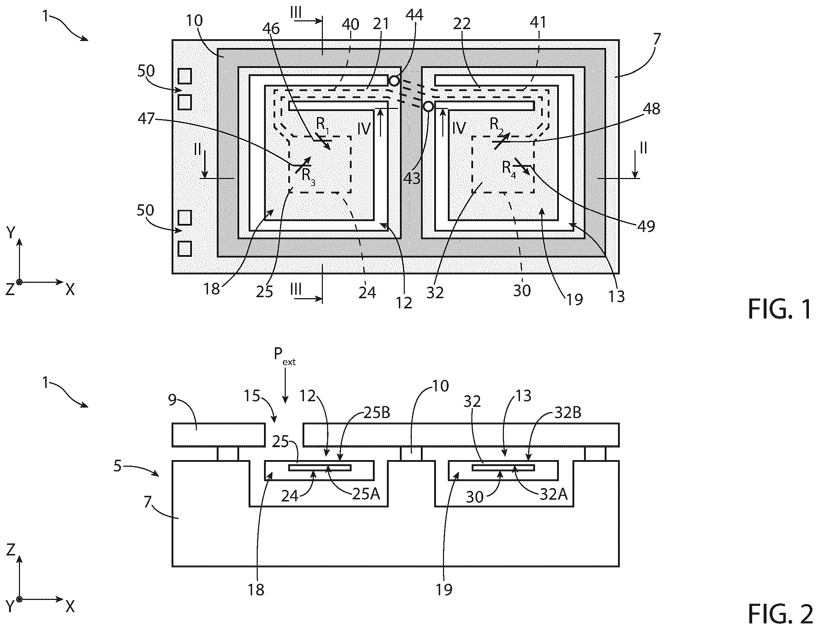

Figures 1 and 2 show a pressure sensor 1, hereinafter also simply referred to as sensor 1, in a Cartesian reference system XYZ having a first axis X, a second axis Y and a third axis Z.

The sensor 1 is of MEMS type.

The sensor 1 may be manufactured through micro- and nano-machining techniques known per se, for example starting from a wafer of semiconductor material, in particular silicon, and subsequent processing steps, for example including lithography, chemical etching, growth, annealing, dicing, bonding, etc., typical of the semiconductor industry.

The sensor 1 is configured to detect an external pressure Pₑₓₜ.

The sensor 1 is formed in a body 5 comprising a lower substrate 7 and an upper substrate 9 mutually bonded through a bonding region 10.

The lower substrate 7 and the upper substrate 9 are of semiconductor material, in particular silicon. However, the lower substrate 7 and the upper substrate 9 may be of different material or comprise portions or layers of different material, for example insulating material, depending on the specific manufacturing processes used.

The bonding region 10 is of a material that allows a hermetic bonding to be obtained between the lower substrate 7 and the upper substrate 9. For example, the bonding region 10 may be of aluminum-germanium (Al-Ge). Bonding through Al-Ge may allow very low pressures to be obtained, for example even lower than 20 mbar.

Figure 1 shows, for clarity, the sensor 1 without the upper substrate 9.

The sensor 1 comprises a first chamber 12 and a second chamber 13 arranged in the body 5.

The first chamber 12 and the second chamber 13 are hermetically separated from each other by the bonding region 10.

In this embodiment, the body 5 comprises an opening 15 that couples the first chamber 12 with the outside of the sensor 1. In other words, the opening 15 causes the first chamber 12 to be at the external pressure Pₑₓₜ.

In the embodiment shown, the opening 15 extends through the upper substrate 9, throughout its thickness along the third axis Z.

The sensor 1 further comprises a first detection structure 18 arranged in the first chamber 12 and a second detection structure 19 arranged in the second chamber 13.

In detail, in this embodiment, the first and the second detection structures 18, 19 are structures suspended in the first and, respectively, in the second chamber 12, 13 through respective elastic elements 21, 22.

The first and the second detection structures 18, 19 and the elastic elements 21, 22 may be of semiconductor material, in particular silicon, formed starting from the same wafer used to form the lower substrate 7, through subsequent processing steps comprising lithography, growth, chemical etching, etc.

The elastic element 21 extends into the first chamber 12 between the first detection structure 18 and the lower substrate 7. The elastic element 22 extends into the second chamber 13 between the second detection structure 19 and the lower substrate 7.

The elastic elements 21, 22 are configured so as to mechanically decouple each the respective detection structure 18, 19 from the lower substrate 7. In this manner, the detection structures 18, 19 may be decoupled by external mechanical stimuli applied on the body 5.

Shape and dimensions of the elastic elements 21, 22 may be chosen, during the design step, based on the desired elastic properties of the elastic elements 21, 22.

The first detection structure 18 comprises a buried cavity 24 that extends within the first detection structure 18 and a membrane 25 that faces the buried cavity 24.

In detail, the membrane 25 has a lower surface 25A facing the buried cavity 24 and an upper surface 25B facing the first chamber 12.

In practice, the buried cavity 24 delimits the membrane 25 at the bottom and the first chamber 12 delimits the membrane 25 at the top.

Position of the buried cavity 24 within the first detection structure 18 and dimensions of the buried cavity 24 may be chosen, during the design step, depending on the desired dimensions of the membrane 25. For example, the membrane 25 may have a thickness, along the third axis Z, comprised for example between 2 µm and 20 µm, and an area, measured in an XY plane, comprised between 40x40 µm² and 600x600 µm².

The second detection structure 19 comprises a buried cavity 30 that extends within the second detection structure 19 and a membrane 32 that faces the buried cavity 30.

In detail, the membrane 32 has a lower surface 32A facing the buried cavity 30 and an upper surface 32B facing the second chamber 13.

In practice, the buried cavity 30 delimits the membrane 32 at the bottom and the second chamber 13 delimits the membrane 32 at the top.

Position of the buried cavity 30 within the second detection structure 19 and dimensions of the buried cavity 30 may be chosen, during the design step, depending on the desired dimensions of the membrane 32. For example, the membrane 32 may have a thickness, along the third axis Z, comprised for example between 2 µm and 20 µm, and an area, measured in the XY plane, comprised between 40x40 µm² and 600x600 µm².

In particular, the first and the second detection structures 18, 19 may be designed to be equal to each other. For example, the membranes 30, 32 may have the same dimensions as each other. This allows the detection accuracy of the sensor 1 to be improved.

The sensor 1 further comprises a channel 40 that extends into the body 5 between the buried cavity 24 and the second chamber 13 and a channel 41 that extends into the body 5 between the buried cavity 30 and the first chamber 12.

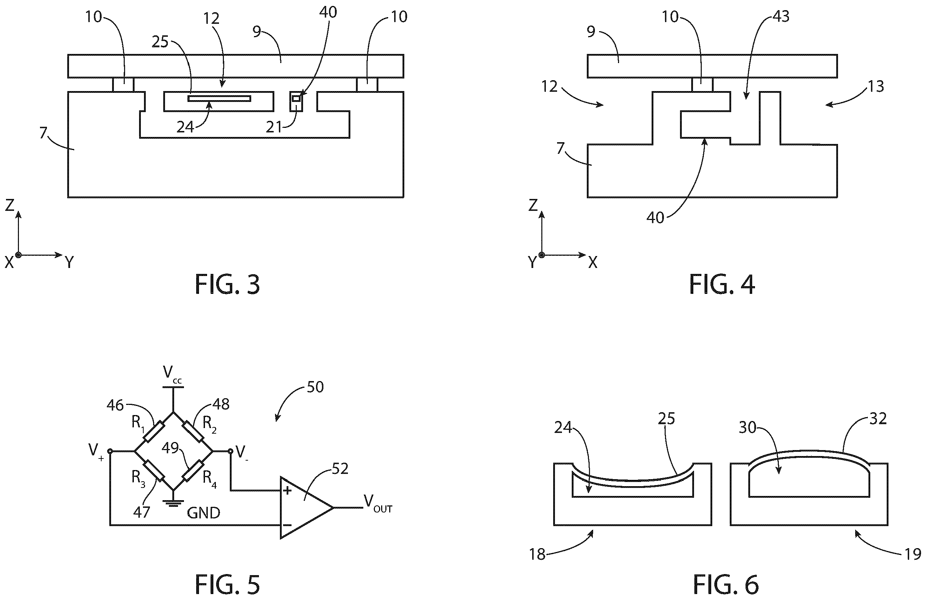

The channel 40, details of which are shown in Figures 3 and 4, is open at a first end on the buried cavity 24 and at a second end on the second chamber 13.

In practice, the channel 40 causes the buried cavity 24 and the second chamber 13 to be at a same pressure P₁.

The channel 41 is open at a first end on the buried cavity 30 and at a second end on the first chamber 12.

In practice, the channel 41 causes the buried cavity 30 and the first chamber 12 to be at a same pressure P₂, which here is equal to the external pressure Pext.

In detail, the channel 40 extends, starting from the buried cavity 24, buried within the first detection structure 18, the elastic element 21 and part of the lower substrate 7, towards the second chamber 13.

In this embodiment, the channel 40 comprises a via 43 that extends, along the third axis Z, from a surface of the lower substrate 7 which faces the second chamber 13 towards the inside of the lower substrate 7. In practice, the via 43 may fluidically couple the buried portion of the channel 40 with the second chamber 13.

In detail, the channel 41 extends, starting from the buried cavity 30, buried within the second detection structure 19, the elastic element 22 and part of the lower substrate 7, towards the first chamber 12.

In this embodiment, the channel 41 comprises a via 44 that extends, along the third axis Z, from a surface of the lower substrate 7 which faces the first chamber 12 towards the inside of the lower substrate 7. In practice, the via 44 may fluidically couple the buried portion of the channel 41 with the first chamber 12.

The buried cavities 24, 30 and the buried portions of the channels 40, 41 may be formed for example through formation and subsequent removal of sacrificial layers; or through subsequent steps comprising growth, lithography, chemical etching and annealing, as for example described in the European patent EP1577656.

The vias 43, 44 may be formed with the same chemical etching used to define the elastic elements 21, 22 and the detection structures 18, 19.

The sensor 1 further comprises one or more transduction elements, here two piezoresistors 46, 47, coupled to the first detection structure 18 and one or more transduction elements, here two piezoresistors 48, 49, coupled to the second detection structure 19.

The piezoresistors 46, 47 are configured to detect a deformation of the membrane 25.

In detail, the piezoresistors 46, 47 have a resistance R₁, R₃, respectively, which is variable as a function of the deformation of the membrane 25.

In particular, the resistances R₁, R₃ are sensitive both to the direction (upwards or downwards along the third axis Z) and to the extent of the deformation of the membrane 25.

In this embodiment, the piezoresistors 46, 47 are configured in such a way that the respective resistances R₁, R₃ undergo, in response to the deformation of the membrane 25, a variation having sign opposite to each other.

For example, in response to a downward deformation of the membrane 25, the piezoresistor 47 may be configured to undergo a positive variation (increase) of the respective resistance R₃ and the piezoresistor 46 may be configured to undergo a negative variation (decrease) of the respective resistance R₁.

The piezoresistors 48, 49 are configured to detect the deformation of the membrane 32.

In detail, the piezoresistors 48, 49 have a resistance R₂, R₄, respectively, which is variable as a function of the deformation of the membrane 32.

In particular, the resistances R₂, R₄ are sensitive both to the direction (upwards or downwards along the third axis Z) and to the extent of the deformation of the membrane 32.

In this embodiment, the piezoresistors 48, 49 are configured in such a way that the respective resistances R₂, R₄ undergo, in response to the deformation of the membrane 32, a variation having sign opposite to each other. For example, in response to an upward deformation of the membrane 32, the piezoresistor 48 may be configured to undergo a positive variation (increase) of the respective resistance R₂ and the piezoresistor 49 may be configured to undergo a negative variation (decrease) of the respective resistance R₄.

The sensor 1 also comprises electrical connection means, comprising contact pads 50 and metal connection tracks (not shown here), which allow the electrical connection of the sensor 1, in particular of the transduction elements 46-49, to an electrical detection circuit for reading the resistances R1-R4.

Figure 5 shows an embodiment of the detection circuit, here indicated by 50, wherein the piezoresistors 46-49 are electrically coupled to each other in a Wheatstone bridge configuration between a supply voltage V_{cc} and ground GND.

In particular, the piezoresistor 46 and the piezoresistor 47 form a half-bridge and are connected in series between the supply voltage V_{cc} and the ground GND. The piezoresistor 48 and the piezoresistor 49 form a half-bridge and are connected in series between the supply voltage V_{cc} and the ground GND.

An operational amplifier 52 is coupled to the piezoresistors 46-49 and provides a voltage Vout.

In use, in presence of the external pressure Pext to be measured, the pressure P₂ of the first chamber 12 and the buried cavity 30 is equal to the external pressure Pext.

Consequently, between the upper surface 25B and the lower surface 25A of the membrane 25 a pressure difference Pext - P₁ is present, and between the upper surface 32B and the lower surface 32A of the membrane 32 a pressure difference P₁ - Pext is present.

In practice, the membranes 25, 32 are subject, in use, to a pressure difference being equal in magnitude but having opposite sign.

Figure 6 shows an example where Pext = P₂ > P₁. In this case, the membrane 25 undergoes a downward deformation, while the membrane 32 undergoes an upward deformation.

The Wheatstone bridge configuration of the transduction elements 46-49 allows a differential detection of the pressure Pext to be obtained; therefore, any spurious-type mechanical stresses that may affect the first and the second detection structures 18, 19 may be canceled as common mode. Consequently, the sensor 1 may have a high rejection of also internal undesired mechanical stimuli. Furthermore, both membranes 25, 32 deform as a function of the external pressure Pext; consequently, both membranes 25, 32 contribute to the useful signal that allows the external pressure Pext to be measured. The sensor 1 may therefore have a high detection sensitivity.

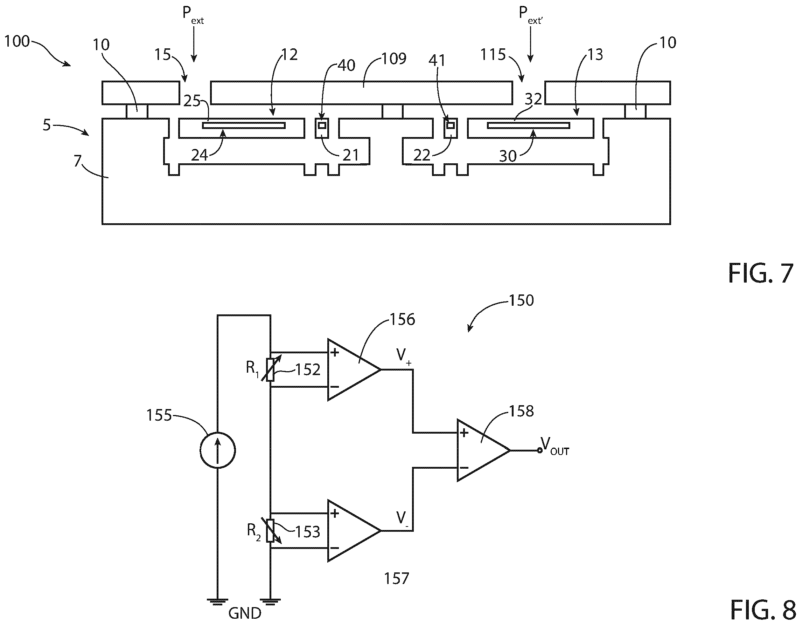

Figure 7 shows a schematic cross-section of a MEMS pressure sensor 100, according to a different embodiment. The sensor 100 has a general structure similar to that of the sensor 1; consequently, common elements are indicated by the same reference numerals and are not further described in detail.

The sensor 100 comprises the body 5 having the lower substrate 7 and an upper substrate, here indicated by 109, mutually bonded through the bonding region 10.

The sensor 100 has the first and the second chambers 12, 13 wherein the first and, respectively, the second detection structure 18, 19 are accommodated.

Also in this embodiment, the first detection structure 18 is a structure suspended through the elastic element 21 and comprises the buried cavity 24 and the membrane 25; and the second detection structure 19 is a structure suspended through the elastic element 22 and comprises the buried cavity 30 and the membrane 32.

Also here, the first chamber 12 and the buried cavity 30 are fluidically coupled by the channel 40, and the second chamber 13 and the buried cavity 24 are fluidically coupled by the channel 41.

In this embodiment, the opening 15 is a first opening of the upper substrate 109 and the upper substrate 109 also comprises a second opening 115 on the second chamber 13.

Although not shown, transduction elements are coupled to the membranes 25, 32 for detecting the respective deformations, similarly to what has been discussed for the sensor 1.

In practice, in this embodiment, the sensor 100 may be used as a differential pressure sensor between two external pressures Pext, Pext'.

In fact, here, the first chamber 12 and the buried cavity 30 are at the pressure Pext, and the second chamber 13 and the buried cavity 24 are at the pressure Pext'.

Finally, it is clear that modifications and variations may be made to the sensors 1, 100 described and illustrated herein without thereby departing from the scope of the present invention, as defined in the attached claims.

For example, the openings 15, 115 may be formed (one or both) through the lower substrate 7 and not through the upper substrate 9, 109.

For example, the detection structures 18, 19, the membranes 25, 32 and the elastic elements 21, 22 may have a different shape from what has been shown, depending on the specific application.

The membranes 25, 32 may have, in-plan, a non-square shape, for example rectangular or of other type, for example regular or non-regular, such as a polygon having a different number of sides or they may have a substantially circular shape.

For example, the membranes 25, 32 may be deformable elements configured to deform as a function of a pressure difference, of a different type and shape from a membrane, for example cantilevers or other.

For example, the detection structures 18, 19 may be structures that are non-suspended and integral with the body 5, in particular with the lower substrate 7.

For example, the pressure sensor may comprise one or more getter layers arranged on one or more walls of one or more of the chambers 12, 13 and the buried cavities 25, 32. In particular, with reference to the absolute pressure sensor described with reference to Figure 1, a getter layer may be arranged on the (lower) internal wall of the upper substrate 9 which faces the second chamber 13, so that the pressure P₁ is as low as possible.

For example, the transduction elements 46-49 may be based on a different transduction principle, for example piezoelectric, capacitive, etc., to detect the deformation of the membranes 25, 32.

The present pressure sensor may have a different number of transduction elements, for example one for each of the membranes 25, 32, and/or the transduction elements may be coupled to each other according to circuit configurations.

For example, Figure 8 shows a different embodiment of the detection circuit, here indicated by 150, which may be used in case the present sensor has only one transduction element 152 coupled to the membrane 25 and only one transduction element 153 coupled to the membrane 32.

The transduction elements 152, 153 are piezoresistors having resistance R₁ and, respectively, R₂.

The piezoresistors 152, 153 are sensitive to the direction along the third axis Z of the deformation of the respective membrane 25, 32. In particular, the piezoresistors 152, 153 are configured so that the respective resistance R₁, R₂ undergoes a positive (or, alternatively, a negative) variation in response to an upward deformation of the respective membrane 25, 32 and a negative (or, alternatively, a positive) variation in response to a downward deformation of the respective membrane 25, 32.

The detection circuit 150 is an Anderson loop wherein the piezoresistors 152, 153 are arranged in series with each other.

In detail, the detection circuit 150 comprises a current generator 155 which provides a reading current to the piezoresistors 152, 153; an operational amplifier 156 coupled at input to the piezoresistor 152; an operational amplifier 157 coupled at input to the piezoresistor 153; and an operational amplifier 158 coupled to the outputs of the operational amplifiers 156, 157 and providing the voltage Vout. In practice, the operational amplifier 158 operates as a subtractor that cancels any common mode stress components that affect the variation of the resistances R₁, R₂.

In this manner, the output voltage Vout is only a function of the external pressure to be measured and, at least as a first approximation, independent of spurious mechanical stresses.

The electrical detection circuits 50, 150 may be integrated in the same die wherein the sensor is integrated, or in a separate die, depending on the specific application.

The electrical connections among the transduction elements may be formed in the die wherein the transduction elements are formed, or in the die wherein the detection circuit is formed.

Finally, the different embodiments described above may be combined to provide further solutions.

## Claims

1. A pressure sensor (1; 100) comprising:
a body (5) having a first chamber (12) and a second chamber (13) hermetically separated from the first chamber;
a first detection structure (18) arranged in the first chamber (12), comprising a first deformable element (25) and a first buried cavity (24) within the first detection structure, wherein the first deformable element is configured to undergo a deformation as a function of a pressure difference between the first chamber and the first buried cavity;
a second detection structure (19) arranged in the second chamber (13), comprising a second deformable element (32) and a second buried cavity (30) within the second detection structure, wherein the second deformable element is configured to undergo a deformation as a function of a pressure difference between the second chamber and the second buried cavity;
**characterised in that** the pressure sensor (1; 100) further comprises:
a first channel (40, 43) extending into the body (5) and configured to fluidically couple the first buried cavity (24) with the second chamber (13); and
a second channel (41, 44) extending into the body (5) and configured to fluidically couple the second buried cavity (30) with the first chamber (12).

2. The pressure sensor according to the preceding claim, wherein the first deformable element (25) has a first face (25A) facing the first buried cavity (24) and a second face (25B) opposite to the first face and facing the first chamber (12), and wherein the second deformable element (32) has a first face (32A) facing the second buried cavity (30) and a second face (32B) opposite to the first face and facing the second chamber (13).

3. The pressure sensor according to claim 1 or 2, wherein the first detection structure (18) is a structure suspended in the first chamber (12) and/or the second detection structure (19) is a structure suspended in the second chamber (13).

4. The pressure sensor according to any of the preceding claims, comprising at least one opening (15; 115) that extends through the body (5) and is configured to couple one of the first and the second chambers with an external pressure (Pext, Pext').

5. The pressure sensor according to the preceding claim, wherein the at least one opening is a first opening (15) configured to fluidically couple the first chamber (12) with the external pressure (Pext), the sensor further comprising a second opening (115) extending through the body (5) and configured to fluidically couple the second chamber (13) with a second external pressure (Pext').

6. The pressure sensor according to any of the preceding claims, wherein the body (5) comprises a lower substrate (7), an upper substrate (9; 109) and a bonding region (10) configured to hermetically couple the upper substrate with the lower substrate.

7. The pressure sensor according to any of the preceding claims, further comprising at least one first transduction element (46, 47; 152) configured to detect the deformation of the first deformable element (25), and at least one second transduction element (48, 49; 153) configured to detect the deformation of the second deformable element (32).

8. The pressure sensor according to the preceding claim, wherein the at least one first transduction element (46, 47; 152) is sensitive to the direction of the deformation of the first deformable element (25) and the at least one second transduction element (48, 49; 153) is sensitive to the direction of the deformation of the second deformable element (32).

9. The pressure sensor according to claim 7 or 8, wherein the at least one first transduction element and/or the at least one second transduction element are piezoresistors.

10. The pressure sensor according to any of the preceding claims, further comprising a detection circuit (50; 150) configured to perform a differential reading of the deformation of the first deformable element (25) and the second deformable element (32).

11. The pressure sensor according to any of the preceding claims, wherein the pressure sensor is of MEMS type.

## Revendications

1. Capteur de pression (1 ; 100) comprenant :
un corps (5) comportant une première chambre (12) et une deuxième chambre (13) séparée hermétiquement de la première chambre ;
une première structure de détection (18) placée dans la première chambre (12), comprenant un premier élément déformable (25) et une première cavité enfouie (24) dans la première structure de détection, dans lequel le premier élément déformable est configuré pour subir une déformation en fonction d'une différence de pression entre la première chambre et la première cavité enfouie ;
une deuxième structure de détection (19) placée dans la deuxième chambre (13), comprenant un deuxième élément déformable (32) et une deuxième cavité enfouie (30) dans la deuxième structure de détection, dans lequel le deuxième élément déformable est configuré pour subir une déformation en fonction d'une différence de pression entre la deuxième chambre et la deuxième cavité enfouie ;
**caractérisé en ce que** le capteur de pression (1 ; 100) comprend en outre :
un premier canal (40, 43) s'étendant dans le corps (5) et configuré pour relier de manière fluidique la première cavité enfouie (24) à la deuxième chambre (13) ; et
un deuxième canal (41, 44) s'étendant dans le corps (5) et configuré pour relier de manière fluidique la deuxième cavité enfouie (30) à la première chambre (12).

2. Capteur de pression selon la revendication précédente, dans lequel le premier élément déformable (25) a une première face (25A) orientée vers la première cavité enfouie (24) et une deuxième face (25B) à l'opposé de la première face et orientée vers la première chambre (12), et dans lequel le deuxième élément déformable (32) a une première face (32A) orientée vers la deuxième cavité enfouie (30) et une deuxième face (32B) à l'opposé de la première face et orientée vers la deuxième chambre (13).

3. Capteur de pression selon la revendication 1 ou 2, dans lequel la première structure de détection (18) est une structure suspendue dans la première chambre (12) et/ou la deuxième structure de détection (19) est une structure suspendue dans la deuxième chambre (13).

4. Capteur de pression selon l'une quelconque des revendications précédentes, comprenant au moins une ouverture (15 ; 115) qui traverse le corps (5) et qui est configurée pour relier l'une des première et deuxième chambres à une pression extérieure (Pext, Pext').

5. Capteur de pression selon la revendication précédente, dans lequel ladite au moins une ouverture est une première ouverture (15) configurée pour relier de manière fluidique la première chambre (12) à la pression extérieure (Pext), le capteur comprenant en outre une deuxième ouverture (115) traversant le corps (5) et configurée pour relier de manière fluidique la deuxième chambre (13) à une deuxième pression extérieure (Pext').

6. Capteur de pression selon l'une quelconque des revendications précédentes, dans lequel le corps (5) comprend un substrat inférieur (7), un substrat supérieur (9 ; 109) et une région de liaison (10) configurée pour accoupler de manière hermétique le substrat supérieur au substrat inférieur.

7. Capteur de pression selon l'une quelconque des revendications précédentes, comprenant en outre au moins un premier élément de transduction (46, 47 ; 152) configuré pour détecter la déformation du premier élément déformable (25), et au moins un deuxième élément de transduction (48, 49 ; 153) configuré pour détecter la déformation du deuxième élément déformable (32).

8. Capteur de pression selon la revendication précédente, dans lequel ledit au moins un premier élément de transduction (46, 47 ; 152) est sensible à la direction de la déformation du premier élément déformable (25) et ledit au moins un deuxième élément de transduction (48, 49 ; 153) est sensible à la direction de la déformation du deuxième élément déformable (32).

9. Capteur de pression selon la revendication 7 ou 8, dans lequel ledit au moins un premier élément de transduction et/ou ledit au moins un deuxième élément de transduction sont des piézorésistances.

10. Capteur de pression selon l'une quelconque des revendications précédentes, comprenant en outre un circuit de détection (50 ; 150) configuré pour effectuer une lecture différentielle de la déformation du premier élément déformable (25) et du deuxième élément déformable (32).

11. Capteur de pression selon l'une quelconque des revendications précédentes, dans lequel le capteur de pression est de type MEMS.

## Patentansprüche

1. Drucksensor (1; 100), umfassend:
einen Körper (5) mit einer ersten Kammer (12) und einer zweiten Kammer (13), die hermetisch von der ersten Kammer abgetrennt ist;
eine erste Detektionsstruktur (18), die in der ersten Kammer (12) angeordnet ist und ein erstes verformbares Element (25) und einen ersten vergrabenen Hohlraum (24) innerhalb der ersten Detektionsstruktur umfasst, wobei das erste verformbare Element so eingerichtet ist, dass es sich in Abhängigkeit von einer Druckdifferenz zwischen der ersten Kammer und dem ersten vergrabenen Hohlraum verformt;
eine zweite Detektionsstruktur (19), die in der zweiten Kammer (13) angeordnet ist und ein zweites verformbares Element (32) und einen zweiten vergrabenen Hohlraum (30) innerhalb der zweiten Detektionsstruktur umfasst, wobei das zweite verformbare Element so eingerichtet ist, dass es sich in Abhängigkeit von einer Druckdifferenz zwischen der zweiten Kammer und dem zweiten vergrabenen Hohlraum verformt;
**dadurch gekennzeichnet, dass** der Drucksensor (1; 100) ferner Folgendes umfasst:
einen ersten Kanal (40, 43), der sich in den Körper (5) erstreckt und so eingerichtet ist, dass er den ersten vergrabenen Hohlraum (24) fluidisch mit der zweiten Kammer (13) koppelt; und
einen zweiten Kanal (41, 44), der sich in den Körper (5) erstreckt und so eingerichtet ist, dass er den zweiten vergrabenen Hohlraum (30) fluidisch mit der ersten Kammer (12) koppelt.

2. Drucksensor nach dem vorhergehenden Anspruch, wobei das erste verformbare Element (25) eine erste Fläche (25A) aufweist, die dem ersten vergrabenen Hohlraum (24) zugewandt ist, und eine zweite Fläche (25B), die der ersten Fläche gegenüberliegt und der ersten Kammer (12) zugewandt ist, und wobei das zweite verformbare Element (32) eine erste Fläche (32A) aufweist, die dem zweiten vergrabenen Hohlraum (30) zugewandt ist, und eine zweite Fläche (32B), die der ersten Fläche gegenüberliegt und der zweiten Kammer (13) zugewandt ist.

3. Drucksensor nach Anspruch 1 oder 2, wobei die erste Detektionsstruktur (18) eine in der ersten Kammer (12) aufgehängte Struktur ist und/oder die zweite Detektionsstruktur (19) eine in der zweiten Kammer (13) aufgehängte Struktur ist.

4. Drucksensor nach einem der vorhergehenden Ansprüche, der mindestens eine Öffnung (15; 115) umfasst, die sich durch den Körper (5) erstreckt und so eingerichtet ist, dass sie eine der ersten und der zweiten Kammer mit einem Außendruck (Pext, Pext') koppelt.

5. Drucksensor nach dem vorhergehenden Anspruch, wobei die mindestens eine Öffnung eine erste Öffnung (15) ist, die so eingerichtet ist, dass sie die erste Kammer (12) fluidisch mit dem Außendruck (Pext) koppelt, wobei der Sensor ferner eine zweite Öffnung (115) umfasst, die sich durch den Körper (5) erstreckt und so eingerichtet ist, dass sie die zweite Kammer (13) fluidisch mit einem zweiten Außendruck (Pext') koppelt.

6. Drucksensor nach einem der vorhergehenden Ansprüche, wobei der Körper (5) ein unteres Substrat (7), ein oberes Substrat (9; 109) und einen Verbindungsbereich (10) umfasst, der so eingerichtet ist, dass er das obere Substrat hermetisch mit dem unteren Substrat koppelt.

7. Drucksensor nach einem der vorhergehenden Ansprüche, der ferner mindestens ein erstes Transduktionselement (46, 47; 152) umfasst, das so eingerichtet ist, dass es die Verformung des ersten verformbaren Elements (25) detektiert, und mindestens ein zweites Transduktionselement (48, 49; 153), das so eingerichtet ist, dass es die Verformung des zweiten verformbaren Elements (32) detektiert.

8. Drucksensor nach dem vorhergehenden Anspruch, wobei das mindestens eine erste Transduktionselement (46, 47; 152) empfindlich gegenüber der Richtung der Verformung des ersten verformbaren Elements (25) ist und das mindestens eine zweite Transduktionselement (48, 49; 153) empfindlich gegenüber der Richtung der Verformung des zweiten verformbaren Elements (32) ist.

9. Drucksensor nach Anspruch 7 oder 8, wobei das mindestens eine erste Transduktionselement und/oder das mindestens eine zweite Transduktionselement Piezoresistoren sind.

10. Drucksensor nach einem der vorhergehenden Ansprüche, der ferner eine Detektionsschaltung (50; 150) umfasst, die so eingerichtet ist, dass sie eine Differenzmessung der Verformung des ersten verformbaren Elements (25) und des zweiten verformbaren Elements (32) durchführt.

11. Drucksensor nach einem der vorhergehenden Ansprüche, wobei der Drucksensor vom MEMS-Typ ist.
